# EUROPÄISCHE PATENTANMELDUNG

(11) **EP 0 999 296 A2**
(43) Veröffentlichungstag der Anmeldung: **10.05.2000**
(21) Anmeldenummer: 99116017.7
(22) Anmeldetag: 14.08.1999
(51) Int. Cl.: C25D 17/00, H05K 3/24

(54) **Einrichtung zum Abtrag einer Beschichtung von Gegenständen**

(30) Priorität: 04.09.1998 DE 19840471
(71) Anmelder: Gebr. Schmid GmbH & Co., D-72250 Freudenstadt (DE)
(72) Erfinder: Schmid, Dieter C., 72250 Freudenstadt (DE)
(74) Vertreter: Patentanwälte Ruff, Beier, Schöndorf und Mütschele

(57) **Zusammenfassung**

Durch eine erfindungsgemäße Einrichtung zum wenigstens teilweisen Abtrag einer Beschichtung von Gegenständen, insbesondere Kontaktiermitteln (19), in einer Galvanisiereinrichtung (11) kann der Abtrag im wesentlichen geregelt erfolgen. Bei einem Abtrag werden die Gegenstände von Steuermitteln (37) gesteuert mit einer Stripp-Spannung beaufschlagt, wobei Überwachungsmittel (34, 39) mit den Steuermitteln verbunden sind und den Verlauf der Spannung und/oder eines Stromes (52) bzw. eines Potentials (41) zumindest teilweise erfassen. In Abhängigkeit von wenigstens einem charakteristischen Abschnitt (44, 46, 54, 56) können die Steuermittel (37) die Spannungsbeaufschlagung ändern, vorzugsweise unterbrechen. Besonders bevorzugt wird die Erfindung bei segmentierten Kontaktierrädern (19) einer Galvanisiereinrichtung (11) für Leiterplatten (17) verwendet.

## Beschreibung

### ANWENDUNGSGEBIET UND STAND DER TECHNIK

Die Erfindung betrifft eine Einrichtung zum wenigstens teilweisen Abtrag einer Beschichtung von Gegenständen in einer Beschichtungseinrichtung durch elektrochemischen Vorgang in einem Elektrolyten, wobei die Gegenstände von Steuermitteln gesteuert zumindest teilweise mit Spannung beaufschlagbar sind. Bei der Beaufschlagung mit Spannung fließt ein Strom, da dieser in Relation zu der Spannung steht, soll im folgenden lediglich von Spannungsbeaufschlagung die Rede sein, womit auch der Stromfluß umfaßt ist. Die Beschichtungseinrichtung ist vorzugsweise eine Galvanisiereinrichtung.

Eine derartige Beschichtungseinrichtung ist beispielsweise aus der DE 196 28 784 bekannt. Es ist vorgeschlagen worden, durch elektrochemischen Vorgang, vorzugsweise in einer Beschichtungseinrichtung, eine Beschichtung von Gegenständen durch Spannungsbeaufschlagung entsprechend abzutragen. Solche Gegenstände werden z.B. in der o.g. DE 196 278 784 als Kontaktiermittel für zu beschichtende Leiterplatten benannt.

Bei der Beschichtung der Leiterplatten werden auch die Kontaktiermittel zumindest teilweise beschichtet, und diese ungewünschte Beschichtung soll entfernt werden.

### AUFGABE UND LÖSUNG

Der Erfindung liegt die Aufgabe zugrunde, eine eingangs beschriebene Einrichtung zu schaffen, die einen wenigstens teilweise Abtrag einer Beschichtung von Gegenständen zuverlässig und vielseitig anpaßbar ermöglicht.

Diese Aufgabe wird durch die Merkmale des Anspruch 1 gelöst. Vorteilhafte Ausgestaltungen sind Gegenstand der Unteranspräche.

Erfindungsgemäß sind die Überwachungsmittel mit den Steuermitteln verbunden, die den Verlauf der Spannung und/oder eines Stromes zumindest teilweise erfassen, wobei auch ein Potential erfaßt werden kann. In Abhängigkeit von wenigstens einem charakteristischen Abschnitt wenigstens eines dieser Verläufe ändern die Steuermittel die Spannungsbeaufschlagung. Auf diese Weise ist ein regelbarer Abtrag möglich, wobei als Regelgröße Spannung bzw. Potential und/oder Strom dienen können. Ebenso können diese Regelgrößen in differenzierter Form ausgewertet werden, vorzugsweise einfach nach der Zeit differenziert, also als Änderung der Regelgröße. Ein charakteristischer Abschnitt des Verlaufs kann einen bestimmten Punkt oder eine Phase des Abtrags, beispielsweise einen Abtrag im wesentlichen der gesamten Beschichtung, anzeigen. Die Steuermittel können in Abhängigkeit von dem wenigstens einen charakteristischen Abschnitt die Spannungsbeaufschlagung beliebig ändern, bevorzugt wird die Spannungsbeaufschlagung unterbrochen bzw. abgestellt. Eine Änderung der Spannungsbeaufschlagung erfolgt bevorzugt durch Leistungsschalter, beispielsweise elektronische Bauelemente oder Leistungsrelais, die von den Steuermitteln gesteuert sind.

Die Gegenstände können anstatt einer vollständigen Bedeckung ihrer Oberfläche auch lediglich teilweise eine zu beseitigende Beschichtung oder Anlagerung von Material aufweisen.

Wenigstens einer der Verläufe des Stromes und/oder der Spannung bzw. des Potentials kann aufgezeichnet und als Vergleichs-Verlauf in einem mit den Steuermitteln verbundenen Speicher gespeichert sein. Bevorzugt wird dies vor dem Serienbetrieb der Beschichtungseinrichtung bzw. bei einer Konfiguration, evtl. auf die jeweiligen Gegenstände und/oder Beschichtung abgestimmt, vorgenommen. Aus diesem gespeicherten Vergleichs-Verlauf können die Steuermittel den wenigstens einen charakteristischen Abschnitt bestimmen. Anstelle eines im wesentlichen gesamten Verlaufs kann lediglich ein Teil eines Verlaufs, der vorzugsweise den charakteristischen Abschnitt enthält, abgespeichert werden.

Ein Erfassen der Spannung und/oder des Stroms bzw. des Potentials kann zur Vereinfachung punktweise in Intervallen erfolgen, vorzugsweise aber im wesentlichen kontinuierlich. So können schnelle Änderungen rechtzeitig erfaßt werden.

Während des normalen Betriebs bzw. Abtrags der Beschichtung können die Überwachungsmittel wenigstens einen der dem gespeicherten Vergleichs-Verlauf entsprechenden Verläufe erfassen. Daran anschließend erfolgt ein Vergleich des erfaßten Verlaufs mit dem gespeicherten Vergleichs-Verlauf. Auf diese Weise wissen die Steuermittel sozusagen, an welchem Punkt des Verlaufs sich der Abtrag momentan befindet und wann der charakteristische Abschnitt erreicht ist.

Eine kontinuierliche Seibstanpassung kann dadurch erreicht werden, daß die Steuermittel in Intervallen wenigstens einen gespeicherten Vergleichs-Verlauf, insbesondere durch Unterlassen des Eingreifens in den Abtrag, neu erfassen und mit dem vorher gespeicherten Verlauf abgleichen. Sie können in Abhängigkeit von dem neu erfaßten Vergleichs-Verlauf den vorher gespeicherten Vergleichs-Verlauf verändern, beispielsweise gemittelte Werte bilden. Beispielsweise wird ein vorher gespeicherter Vergleichs-Verlauf durch einen neu erfaßten Vergleichs-Verlauf ersetzt.

Bevorzugt bestimmen die Steuermittel als den wenigstens einen charakteristischen Abschnitt einen Bereich mit einer Änderung der Steigung des Verlaufes, vorzugsweise mit einer starken Änderung der Steigung. Ein Bereich kann zeitlich, evtl. bis auf einen einzelnen Punkt, verkürzt werden, ab dem eine gewisse vorgegebene Steigungsänderung erreicht oder ein bestimmter Betrag einer Steigung über- oder unterschritten ist. Bevorzugt bestimmen die Steuermittel als den wenigstens einen charakteristischen Abschnitt einen Abfall bzw. Rückgang der Steigung, insbesondere einen Rückgang in etwa auf Null.

Charakteristische Abschnitte können auch bestimmte Spannungs- oder Stromwerte bzw. Differenzen sein, deren Erreichen erfaßt wird. Eine Überwachung der Verläufe der jeweiligen Größen wird hier als besonders vorteilhaft angesehen.

Es ist möglich, daß die Steuermittel vor dem Erreichen des charakteristischen Abschnitts die Spannungsbeaufschlagung ändern, insbesondere um eine bestimmbare Zeitspanne vor diesem Erreichen. Dazu erfolgt bevorzugt ein Abspeichern eines Vergleichs-Verlaufes und eine im wesentlichen ununterbrochene Überwachung der Meßgröße und einen Vergleich mit dem Vergleichsverlauf. Durch diesen Vergleich läßt sich eine gewisse Voraussage des Ablaufs treffen. Dies kann von Vorteil sein, wenn das Erreichen des charakteristischen Abschnitts bereits einen Zustand darstellt oder in nächster zeitlicher Nähe ankündigt, der vermieden werden soll. Anstelle einer Zeitspanne ist ein bestimmbarer Betrag der Meßgröße verwendbar.

Die Erfindung ermöglicht es, die Gegenstände als Ganzes von einer Beschichtung zu befreien. Bevorzugt sind die Gegenstände abschnittsweise mit Spannung zum Abtrag der Beschichtung beaufschlagbar. Die Abschnitte sind vorzugsweise gegeneinander isoliert, so daß es möglich ist, genau einen Abschnitt zu beaufschlagen bzw. dessen Beschichtung abzutragen.

Vorteilhaft überwachen die Steuermittel mit den Überwachungsmitteln das Potential des Elektrolyten und ändern in Abhängigkeit von diesem Potentialverlauf wie oben beschrieben die Spannungsbeaufschlagung. Besonders bevorzugt wird das Potential zwischen einer Elektrode, die vorzugsweise aus demselben Material wie die zu beseitigende Beschichtung besteht, in dem Elektrolyten und dem Gegenstand überwacht bzw. gemessen.

Mit Vorteil kann eine erfindungsgemäße Einrichtung in Fällen eingesetzt werden, in denen die Gegenstände Funktionsbestandteil der Beschichtungseinrichtung sind, beispielsweise Kontaktiermittel zur elektrischen Kontaktierung von Leiterplatten oder anderen üblicherweise zu beschichtenden Teilen bei deren Beschichtung. Eine Beschichtung besteht im üblichen aus leitfähigem Material, insbesondere einem Metall wie beispielsweise Kupfer. Da derartige Kontaktiermittel die Leiterplatten mit einer zum Auftrag einer Beschichtung nötigen Spannung versorgen, lagert sich an ihnen leitfähiges Material an. Dies ist unerwünscht, und mit der vorliegenden Erfindung kann unter anderem diese unerwünschte Anlagerung bzw. Beschichtung im wesentlichen wieder entfernt werden.

Die Kontaktiermittel können zur abschnittsweisen Kontaktierung segmentiert sein, vorzugsweise elektrisch gegeneinander isoliert sein und/oder eine in wenistens zwei Abschnitte unterteilte Außenfläche aufweisen. Die Abschnitte bzw. Segmente sind vorzugsweise gegeneinander isoliert und einzeln mit Anschlußmitteln zur jeweiligen Beaufschlagung mit Spannung leitend verbindbar oder verbunden. Eine Möglichkeit ist eine im wesentlichen mechanische Kommutierung, alternativ sind Leistungsschalter, evtl. als elektronische Bauelemente, möglich.

Die Gegenstände können aus Metall sein, es bieten sich je nach Elektrolyt chemisch und/oder elektrochemisch beständige Metalle an, beispielsweise Titan. Eine Außenfläche der Gegenstände, vorzugsweise eine in Abschnitte unterteilte Außenfläche, kann zumindest teilweise aus Metall bestehen. Vorteilhaft ist dies ein Edelmetall, beispielsweise Platin. Ein zumindest teilweiser Überzug der Außenfläche der Gegenstände mit einem Edelmetall kann bewirken, daß diese nicht in dem Elektrolyten passivieren. So kann beispielsweise die Verwendung als Kontaktiermittel sichergestellt werden.

Entsprechend einer Möglichkeit der Erfindung sind die Gegenstände als umlaufende Kontaktierräder ausgebildet, die mit einer segmentierten Lauffläche an zu beschichtenden Leiterplatten o. dgl. anliegen. Die Segmente sind bevorzugt mit einem Edelmetall überzogen, gegeneinander isoliert und einzeln kontaktierbar. Die Leiterplatten sind mit leitfähigem Material zu beschichten. Durch Beaufschlagung wenigstens eines Segmentes mit einer Stripp-Spannung während einer Abtrag-Phase kann leitfähiges Material, das sich an der Außen- bzw. Lauffläche dieses wenigstens einen Segmentes angelagert hat, so lange abgetragen werden, bis die Überwachungsmittel eine charakteristische Änderung des Verlaufs des gemessenen Potentials des Elektrolyten erfassen und als solche erkennen. Dies bedeutet, daß sich das Potential dann ändert, wenn an wenigstens einer Stelle das leitfähige Material abgetragen wurde und ein Teil der Außenfläche des Kontaktierrades zutage tritt bzw. mit dem Elektrolyten in Verbindung kommt. Daraufhin unterbrechen die mit den Überwachungsmitteln verbundenen Steuermittel die Beaufschlagung dieses Segmentes mit der Stripp-Spannung. Ein weiteres Beaufschlagen könnte einen unerwünschten Abtrag des metallischen Überzugs der Kontaktierräder zur Folge haben. Somit kann durch die vorliegende Erfindung eine Regelung, eventuell eine vorausblickende bzw. zeitlich vorgreifende Regelung, eines Abtrags einer Beschichtung von Gegenständen durch elektrochemischen Vorgang in einem Elektrolyten erreicht werden. In einer Galvanisiereinrichtung läuft dann sowohl eine Beschichtung von Leiterplatten als auch ein Abtrag von Material von Kontaktiermitteln ab.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränkt die unter diesen gemachten Aussagen nicht in ihrer Allgemeingültigkeit.

### KURZBESCHREIBUNG DER ZEICHNUNGEN

Ein Ausführungsbeispiele der Erfindung sind in den Zeichnungen dargestellt und werden im folgenden näher erläutert. In den Zeichnungen zeigen:
- Fig. 1: einen schematischen Teilguerschnitt durch eine Galvanisiereinrichtung,
- Fig. 2: das Funktionsschema der Potential- oder Stromüberwachung über die Steuermittel,
- Fig. 3: einen beispielhaften Potentialverlauf, in den der charakteristische Abschnitt eingezeichnet ist,
- Fig. 4: einen beispielhaften Stromverlauf, in den ebenfalls der charakteristische Abschnitt eingezeichnet ist und
- Fig. 5: einen beispielhaften Verlauf eines getakteten Entschichtungsvorganges mit Potentialüberwachung.

### DETAILLIERTE BESCHREIBUNG DER AUSFÜHRUNGSBEISPIELE

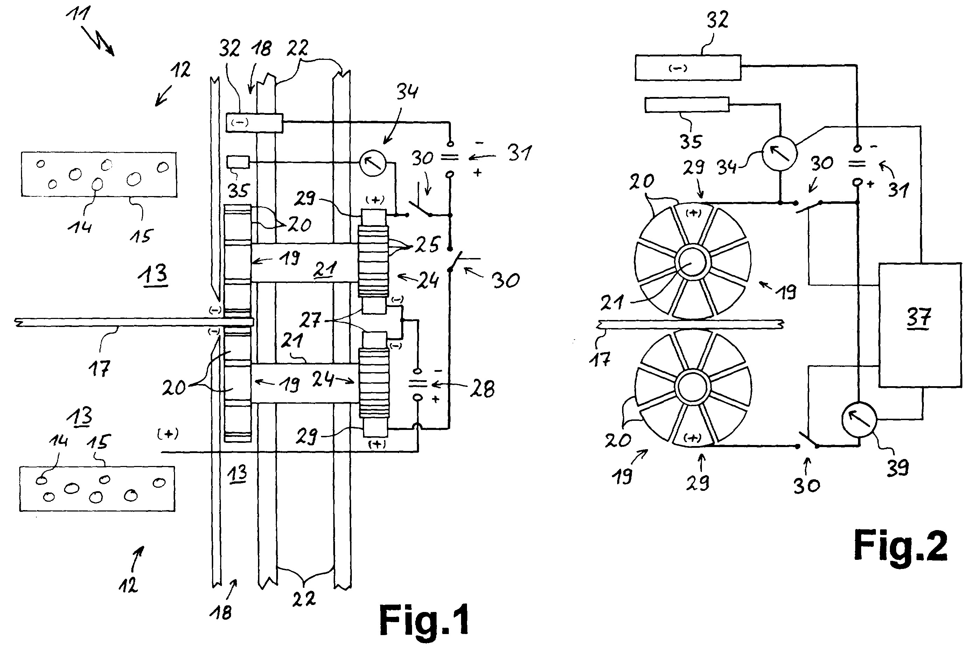

Fig. 1 zeigt eine Galvanisiereinrichtung 11 mit einer Beschichtungskammer 12, die mit einem Elektrolyten 13 gefüllt ist. Als Beschichtungsmaterial sind hier beispielhaft Kupferkugeln 14 in sogenannten Anodenkörben 15 vorgesehen.

In der Beschichtungskammer 12 verläuft eine Leiterplatte 17, deren Rand in einer Kontaktierkammer 18 endet. An diesem Rand liegen Kontaktierräder 19 mit ihrer Lauffläche an, die in Segmente 20 unterteilt ist. Die Kontaktierräder 19 sitzen auf einer Welle 21, deren rechtes Ende, durch Abtrennungen 22 von der Beschichtungskammer 12 getrennt, Anschlußmittel 24 aufweist. Diese sind nach Art eines Kommutators mit einzelnen Kommutatorsektoren 25 versehen, von denen jeweils mindestens einer mit einem Segment 20 verbunden ist, beispielsweise über eine nicht dargestellte Leitung innerhalb der Welle 21. An der einander zugewandten Seite der Anschlußmittel 24 liegen Schleifer 27 an, die mit dem Minuspol einer Galvanisierungsstromquelle 28 verbunden sind. Deren Pluspol endet in der Beschichtungskammer 12 und legt den Elektrolyten 13 sowie die Anodenkörbe 15 samt Kupferkugeln 14 auf dieses Potential. An den abgewandten Seiten sind an den Anschlußmitteln 24 Zusatzschleifer 29 vorgesehen, die jeweils über Schalter 30 mit dem Pluspol einer Stripp-Spannungsquelle 31 verbunden sind. Deren Minuspol wiederum ist mit einer Entmetallisierungskathode 32 in der Kontaktierkammer 18 verbunden. Alternativ kann die negativ beaufschlagte Leiterplatte 17 zur Entmetallisierung dienen.

Zur detaillierten Beschreibung sowie Funktionsweise einer derartigen, mit segmentierten Kontakträdern 19 versehenen Galvanisiereinrichtung 11 wird z.B. auf die eingangs genannte Patentanmeldung verwiesen.

Als Beispiel für Überwachungsmittel ist ein Potentialmeßgerät 34 einerseits mit dem Zusatzschleifer 29 und andererseits mit einer Meßelektrode 35 in der Kontaktierkammer 18 verbunden. Die Meßelektrode 35 besteht bevorzugt aus dem gleichen Material wie die von den Kontaktierrädern 19 abzutragende Beschichtung, in diesem Fall aus Kupfer. Werden lediglich Regelgrößenänderungen, also z.B. Potentialänderungsdifferenzen, erfaßt, so können einfache Meßelektroden verwendet werden, die nicht geeicht sein müssen. Vorteilhaft können zur Erfassung von Potentialdifferenzen die Potentialmeßgeräte 34 nur mit den Meßelektroden 35 verbunden sein. Der Übersichtlichkeit halber sind in Fig. 1 keine Steuermittel, die mit dem Potentialmeßgerät 34 und den Schaltern 30 verbunden sind, eingezeichnet.

Die Fig. 2 zeigt zur Veranschaulichung der Strom- und Potentialüberwachung die segmentierten Kontaktierräder 19 von der Seite sowie die schematisch dargestellten Zusatzschleifer 29, die Stripp-Spannungsquelle 31 sowie Steuermittel in Form einer Steuerung 37. In der Seitenansicht der Kontaktierräder 19 kann man deren Einteilung in Segmente 20 gut erkennen, die gegeneinander isoliert sind. Über die Zusatzschleifer 29 erfolgt eine genaue Kontaktierung der Segmente 20, um ein Kurzschließen zweier benachbarter Segmente 20 zu vermeiden. Hier ist zu beachten, daß die Zusatzschleifer 29 in Wirklichkeit über die Anschlußmittel 24 bzw. die Kommutatorsektoren mit den Segmenten 20 verbunden sind. Die Anschlußmittel 24 können im wesentlichen gleich wie die Kontaktierräder 19 ausgeführt sein.

Mittels der Zusatzschleifer 29 sind die Segmente 20 an den Pluspol der Stripp-Spannungsquelle 31 gelegt. Diese Verbindung ist für jedes Kontaktierrad 19 bzw. jeden Zusatzschleifer 29 durch die Schalter 30 einzeln herzustellen oder zu trennen. Die Schalter 30 sind mit der Steuerung 37, die beispielsweise eine sogenannte SPS-Steuerung sein kann, verbunden und können durch diese ausgelöst werden.

Der Minuspol der Stripp-Spannungsquelle 31 ist mit der Entmetallisierungskathode 32 verbunden. Da sich sowohl die Kontaktierräder 19 als auch die Entmetallisierungskathode 32 in dem Elektrolyten 13 befinden, kann eine unerwünschte Metallschicht an der Oberfläche der Segmente 20 durch das Potentialgefälle zu der Entmetallisierungskathode oder der Leiterplatte 17 hin von den Segmenten lösen. In dem dargestellten Beispiel ist diese unerwünschte Schicht eine Kupferschicht, die sich bei der Kontaktierung der Segmente 20 an die Leiterplatte 17 unter Beaufschlagung mit negativem Potential aus der Galvanisierungsstromquelle 28 an der Oberfläche der Segmente angelagert hat. Um ein zu starkes Anwachsen dieser Schicht sowie ein Zuwachsen der Isolierungen zwischen den Segmenten 20 zu vermeiden, soll diese Beschichtung durch eine erfindungsgemäße Einrichtung abgetragen werden, vorzugsweise geregelt. Eine Regelung kann durch Potentialmessung über eine Meßelektrode 35 in dem Elektrolyten 13 gegenüber den Segmenten 20 mittels des Potentialmeßgeräts 34 erfolgen. Zusätzlich oder alternativ kann der durch die Beaufschlagung mit der Stripp-Spannung fließende Strom in jeder einzelnen Zuleitung zu den Zusatz-schleifern 29 mittels eine Strommeßgerätes 39 überwacht werden. Die Meßgeräte 34 und 39 sind mit der Steuerung 37 verbunden. Diese wertet die Verläufe der Meßgrößen, also der Stripp-Spannung oder des fließenden Stromes, aus, um in Abhängigkeit davon, insbesondere von deren Änderungen, die Schalter 30 zu öffnen oder zu schließen. Die Steuerung 37 kann weitere Funktionen aufweisen, beispielsweise ein erneutes Schließen der Schalter 30 zu einem bestimmten, evtl. genau gemessenen, Zeitpunkt, an dem die Zusatzschleifer 29 durch Drehen der Kontaktierräder 19 und der Kommutatorsektoren 25 mit einem neuen Segment 20 leitend verbunden sind. Möglich sind hier beispielsweise Winkelgeber an der Welle 21 bzw. den Kontaktiermitteln 24, die der Steuerung 37 melden, wenn ein neues Segment 20 allein mit den Zusatzschleifern 29 leitend verbunden ist.

Vorteilhaft ist jedem Kontaktierrad 19 eine eigene Meßelektrode 35 mit eigenen Meßgeräten zugeordnet. Um Verfälschungen auszuschließen, können die einzelnen Meßelektroden 35 voneinander zumindest teilweise abgeschirmt sein.

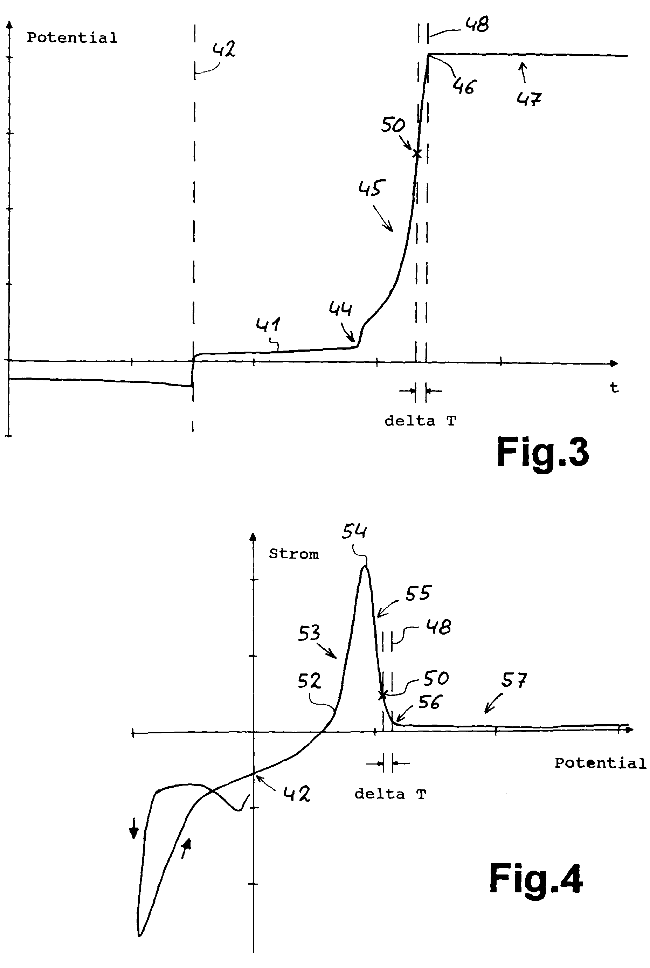

Fig. 3 zeigt beispielhaft einen möglichen Verlauf eines Potentials 41 über der Zeit. Dieser Potentialverlauf 41 entspricht in etwa einem in einer Versuchsanlage gemessenen Potentialverlauf. Bei verschiedenen Ausführungen der Erfindung kann er unter Umständen erheblich von dem hier gezeigten abweichen. Es wird jedoch immer charakteristische Punkte bzw. Abschnitte in dem Verlauf 41 geben, die ähnlich wie bei dem gezeigten Beispiel eine im folgenden beschriebene Bestimmung von Zuständen bzw. Ablaufphasen eines Abtrags ermöglichen.

Der erste Abschnitt des Potentialverlaufs 41 verläuft im negativen. Ab dem Abtragsbeginn 42 liegt, entsprechend der Beaufschlagung mit Stripp-Spannung durch die Stripp-Spannungsguelle 31, der Potentialverlauf 41 im Positiven und zeigt einen flachen Anstieg mit geringem Potential. Hier beginnt der Abtrag der störenden Beschichtung der Segmente 20. Nach einem gewissen Zeitpunkt weist der Potentialverlauf 41 einen starken Aufwärtsknick 44 auf, der sehr schnell in eine langgezogene Anstiegsphase 45 des Potentials mit zunehmender Steigung übergeht. Das Ende der Anstiegsphase 45 bildet ein starker Abwärtsknick 46, der in eine Konstantphase 47 mit etwa konstantem Potential überleitet. Der Abwärtsknick 46 zeigt das Abtragsende 48 der Kupferbeschichtung von den Kontaktierrädern 19 an. Hier wird auch und vor allem Material von der eigentlichen Oberfläche der Segmente 20, beispielsweise ein Platinschutzüberzug, abgetragen, was mit der Erfindung unter anderem vermieden werden soll. Aus diesem Grund sollte spätestens am Abwärtsknick 46 durch Öffnen des zugehörigen Schalters 30 über die Steuerung 37 dieses Segment 20 von der Stripp-Spannungsquelle 31 getrennt werden, um den Übergang in die Konstantphase 47 zu vermeiden.

Gemäß einer Ausführungsvariante der Erfindung kann jeweils ein solcher Abwärtsknick 46 als charakteristischer Abschnitt des Potentialverlaufs 41 durch die Steuerung 37 erkannt werden und zum Abschalten führen. Dies ist beispielsweise durch Differenzierung des gemessenen Potentialwertes zur Ermittelung der Steigung des Potentialverlauts 41 möglich. Sind die Anstiegswerte des Potentialverlaufs 41 während der Anstiegsphase 45 ausreichend unterschiedlich, ist es weiters möglich, bei einem bestimmten Steigungswert, also evtl. vor Erreichen des Abwärtsknicks 46, den Abtrag abzustellen. Dies ist eine Möglichkeit auf alle Fälle einen Abtrag eines Schutzüberzugs der Segmente 20 zu vermeiden.

Eine weitere Möglichkeit ist das Abspeichern eines Potentialverlaufs 41 als Vergleichs-Potentialverlauf. Während eines Abtragsvorgangs kann das Potential überwacht und der Potentialverlauf 41 mit dem gespeicherten Vergleichs-Verlauf verglichen werden. Auf diese Weise, vor allem anhand markanter Abschnitte wie dem Aufwärtsknick 44, läßt sich sowohl die Anstiegsphase 45 als auch ihr Verlauf sehr gut erfassen. Damit ist die Bestimmung eines Abschaltzeitpunktes 50 möglich, der ein Stück vor Erreichen des Abwärtsknicks 46 bzw. eine Zeitspanne delta T davor liegt. Um einen jederzeit möglichst aktuellen Vergleichs-Verlauf zur Verfügung zu haben, kann er in bestimmten Intervallen durch Erreichen oder sogar Passieren des Abwärtsknicks 46 mit den wesentlichen Abschnitten neu erfaßt werden.

Fig. 4 zeigt einen Verlauf des Stroms 52, der während des Abtrags über das mit Stripp-Spannung beaufschlagte Segment 20 fließt, über dem Potential. Der links von der Stromachse liegende Bereich des Stromverlaufs 52 ist für die vorliegende Erfindung ohne Bedeutung. Sobald der Stromverlauf 52 positives Potential aufweist, setzt der Abtragsbeginn 42 ein. Der Strom steigt in einer Aufwärtsphase 53 in den positiven Bereich an, passiert einen Hochpunkt 54 und fällt anschließend in einer Abwärtsphase 55 wieder ab. Kurz vor dem Rückgang auf Null weist der Stromverlauf 52 einen Endknick 56 auf, an dem sich seine Steigung von stark negativ auf etwa Null bzw. knapp darunter ändert. Danach läuft er, ähnlich wie der Potentialverlauf 41, in eine Konstantphase 57 mit geringem Stromfluß über.

Das Abtragsende 48 liegt hier in etwa in dem Endknick 56. Ausgehend von diesem Abtragsende 48 kann, ähnlich wie oben beschrieben, der Abschaltzeitpunkt 50 um eine Zeitspanne delta T davor gewählt bzw. bestimmt werden. Ähnlich wie der Potentialverlauf 41 ist der hier dargestellte Stromverlauf 52 in einer Versuchseinrichtung aufgenommen. Er kann jedoch stark von dem hier gezeigten abweichen, wenn auch charakteristische Abschnitte wie Hochpunkt 54 und/oder Endknick 56 in ähnlicher Weise, auf jeden Fall aber deutlich erkennbar, vorhanden sein werden. Die Überwachung des Stromverlaufs 52 bzw. die Bestimmung des Abschaltzeitpunkts 50 kann wie oben beschrieben erfolgen.

Durch ein Wählen des Abschaltzeitpunkts 50 um die Zeitspanne delta T vor dem Abtragsende der Kupterschicht ist es unter Umständen möglich, einen aufwendigen und teuren Platinüberzug der im wesentlichen aus Titan bestehenden Segmente 20 der Kontaktierräder 19 zu vermeiden. Derzeit erfolgt eine aufwendige Beschichtung mit Platin, da das Titan sofort in einem sauren Elektrolyten passiviert und somit eine Beschichtung von Leiterplatten 17 mit Kupfer nicht oder nur mangelhaft möglich ist. Durch ein Festlegen des Abschaltzeitpunkts 50 um eine Zeitspanne delta T vor dem Abtragsende 48 ist es möglich, jederzeit eine vollständige Kupferbeschichtung der Kontaktflächen der Segmente 20 zu erhalten, da sie nicht vollständig, jedenfalls nicht bis auf die Titan-Oberfläche der Segmente 20, abgetragen wird.

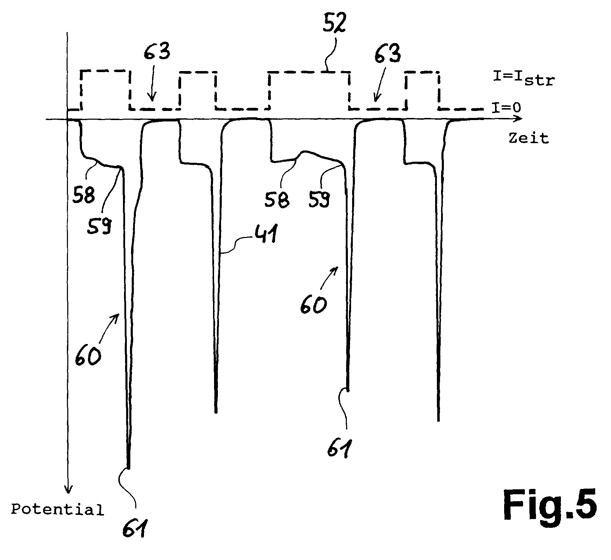

Die Fig. 5 zeigt einen beispielhaften Ablauf eines Entschichtens mehrerer Gegenstände bzw. Segmente 20 eines Kontaktierrades 19. Dabei ist das mit der Meßelektrode 35 erfaßte Potential 41 über der Zeit aufgetragen sowie, gestrichelt dargestellt, der Verlauf des Stromes 52. In Abhängigkeit von dem Verlauf des Potentials 41 beträgt der Strom den Wert ^{I}str (Entschichtung) oder I = 0 (Entschichtung im wesentlichen abgeschlossen).

Wird der Strom 52 eingestellt, fällt das Potential 41 erst ein wenig ab, geht über in einen flachen Verlauf einer Abtragsphase 58, um dann ähnlich zu Fig. 3 mit einem Abwärtsknick 59 in eine Abstiegsphase 60 mit besonders großer negativer Steigung überzugehen. Als charakteristischer Abschnitt ist in diesem Beispiel ein bestimmter Steigungsgrenzwert vorgegeben, der im Abschaltpunkt 61 erreicht wird. Nachdem der Steigungsgrenzwert erreicht worden ist, wird der Abschaltpunkt 61 von der Steuerung 37 erkannt und der Strom 52 abgestellt (I = 0). In diesem Beispiel ist eine gewisse Ruhephase 63 vorgesehen, die in dem dargestellten Beispiel jeweils eine feste Zeit beträgt. Alternativ ist es vorteilhaft möglich, die Ruhephase 63 so lange zu halten, daß sie zusammen mit der Einschaltdauer des Stromes 52 eines feste Zeitdauer ergibt, vorzugsweise diejenige Zeitdauer, die ein einzelnes Segment 20 eines Kontaktierrades 19 kontaktiert wird. Auf diese Weise ist sichergestellt, daß beim nächsten Einschalten nach der Ruhephase 63 das nächste Segment entschichtet wird und nicht noch einmal das gleiche.

Im wesentlichen sehen die Potentialverläufe gleich aus, lediglich die Abtragsphase 58 ist unterschiedlich lang. Der starke Abfall des Verlaufs zu Beginn nach dem Einschalten des Stromes 52 erreicht den Steigungsgrenzwert noch nicht. Alternativ ist es möglich, die Potentialüberwachung erst nach einem gewissen Zeitfenster, das den Abfall zu Beginn abdeckt, einzuschalten.

## Patentansprüche

1. Einrichtung zum wenigstens teilweisen Abtrag einer Beschichtung von Gegenständen (19) in einer Beschichtungseinrichtung (11) durch elektrochemischen Vorgang in einen Elektrolyten (13), wobei die Gegenstände (19) von Steuermitteln (37) gesteuert zumindest teilweise mit Spannung beaufschlagbar sind, dadurch gekennzeichnet, daß Überwachungsmittel (34, 39) mit den Steuermitteln (37) verbunden sind, die den Verlauf der Spannung und/oder eines Stromes (52) bzw. eines Potentials (41) zumindest teilweise erfassen, wobei die Steuermittel (37) in Abhängigkeit von wenigstens einem charakteristischen Abschnitt (44, 46, 54, 56) wenigstens eines dieser Verläufe die Spannungsbeaufschlagung ändern.

2. Einrichtung nach Anspruch 1, dadurch gekennzeichnet, daß die Steuermittel (37) in Abhängigkeit von dem wenigstens einen charakteristischen Abschnitt (44, 46, 54, 56) die Spannungsbeaufschlagung unterbrechen.

3. Einrichtung nach Anspruch 1 oder 2, dadurch gekennzeichnet, daß wenigstens einer der Verläufe des Stromes (52) und/oder der Spannung bzw. des Potentials (41) aufgezeichnet und als Vergleichs-Verlauf in einem Speicher gespeichert ist, vorzugsweise vor der Inbetriebnahme der Beschichtungseinrichtung (11), wobei die Steuermittel (37) aus diesem Vergleichs-Verlauf den wenigstens einen charakteristischen Abschnitt (44, 46, 54, 56) bestimmen.

4. Einrichtung nach Anspruch 3, dadurch gekennzeichnet, daß die Überwachungsmittel (34, 39) während des Abtrags wenigstens einen der Verläufe des Stromes (52) und/oder der Spannung bzw. des Potentials (41) erfassen und die Steuermittel (37) diesen Verlauf mit dem wenigstens einen gespeicherten Vergleichs-Verlauf vergleichen.

5. Einrichtung nach einem der vorhergehenden Ansprüche, dadurch gekennzeichnet, daß die Steuermittel (37) in Intervallen wenigstens einen gespeicherten Vergleichs-Verlauf, insbesondere durch Unterlassen des Eingreifens in den Abtrag, neu erfassen und mit dem vorher gespeicherten abgleichen, wobei vorzugsweise die Steuermittel (37) in dem Speicher den vorher gespeicherten Vergleichs-Verlauf in Abhängigkeit von dem neu erfaßten Vergleichs-Verlauf verändern, insbesondere durch den neu erfaßten Vergleichs-Verlauf ersetzen.

6. Einrichtung nach einem der vorhergehenden Ansprüche, dadurch gekennzeichnet, daß die Steuermittel (37) als den wenigstens einen charakteristischen Abschnitt (44, 46, 54, 56) einen Bereich, insbesondere einen Punkt, mit einer Änderung der Steigung des Verlaufes bestimmen, vorzugsweise mit einer starken Änderung der Steigung.

7. Einrichtung nach einem der vorhergehenden Ansprüche, dadurch gekennzeichnet, daß die Steuermittel (37) vor dem Erreichen des charakteristischen Abschnitts (44, 46, 54, 56) die Spannungsbeaufschlagung ändern, insbesondere um eine bestimmbare Zeitspanne (delta T) vor dem Erreichen des charakteristischen Abschnitts.

8. Einrichtung nach einem der vorhergehenden Ansprüche, dadurch gekennzeichnet, daß die Gegenstände (19) abschnittsweise mit Spannung zum Abtrag der Beschichtung beaufschlagbar sind, wobei vorzugsweise genau ein Abschnitt (20) eines Gegenstandes (19), der mit dem restlichen Gegenstand nicht leitend verbunden ist, beaufschlagbar ist.

9. Einrichtung nach einem der vorhergehenden Ansprüche, dadurch gekennzeichnet, daß die Steuermittel (37) mit den Überwachungsmitteln (34) das Potential des Elektrolyten (13) überwachen und in Abhängigkeit von diesem Potentialverlauf (41) die Spannungsbeaufschlagung ändern, wobei sie vorzugsweise das Potential zwischen einer Elektrode (35) aus dem Beschichtungsmaterial in dem Elektrolyten (13) und dem Gegenstand (19) überwachen.

10. Einrichtung nach einem der vorhergehenden Ansprüche, dadurch gekennzeichnet, daß die Gegenstände Funktionsbestandteil der Beschichtungseinrichtung sind, insbesondere Kontaktiermittel (19) zur elektrischen Kontaktierung von Leiterplatten (17) o.dgl. bei deren Beschichtung.

11. Einrichtung nach Anspruch 10, dadurch gekennzeichnet, daß die Kontaktiermittel (19) segmentiert und elektrisch gegeneinander isoliert sind und/oder eine in wenigstens zwei gegeneinander isolierte Abschnitte (20) unterteilte Außenfläche aufweisen, wobei insbesondere die Abschnitte (20) einzeln mit Anschlußmitteln (24) zur Beaufschlagung mit Spannung leitend verbindbar und/oder verbunden sind.

12. Einrichtung nach Anspruch 10 oder 11, dadurch gekennzeichnet, daß die Gegenstände als umlaufende Kontaktierräder (19) ausgebildet sind, die mit einer segmentierten Lauffläche an zu beschichtenden Leiterplatten (17) o.dgl. anliegen, wobei die Segmente (20) mit einem Edelmetall überzogen, gegeneinander isoliert und einzeln kontaktierbar sind.
